# EUROPEAN PATENT APPLICATION

(11) **EP 4 632 788 A1**
(43) Date of publication of application: **15.10.2025**
(21) Application number: 25166701.0
(22) Date of filing: 27.03.2025
(51) Int. Cl.: H01J 37/22, H01J 37/28

(54) **CHARGED PARTICLE BEAM APPARATUS AND ANALYSIS METHOD**

(30) Priority: 09.04.2024 JP 2024062765
(71) Applicant: Jeol Ltd., Akishima-shi, Tokyo 196-8558 (JP)
(72) Inventor: NAGATOMO, Kei, Tokyo, 196-8558 (JP); SUZUKI, Shintaro, Tokyo, 196-8558 (JP)
(74) Representative: Boult Wade Tennant LLP

(57) **Abstract**

A charged particle beam apparatus includes: a measurement unit that scans a sample with a charged particle beam to capture a sample image; an image acquisition unit that acquires a plurality of sample images captured by the measurement unit from a plurality of regions of the sample, and acquires a feature image that is an image of a feature object contained in the sample from each of the plurality of sample images; and an analysis unit that acquires information on the feature object based on the feature image, wherein the image acquisition unit acquires a plurality of feature images by repeating: processing of selecting one mode from among a plurality of modes to acquire the feature image based on a proportion of a region of the feature object occupying a field of view in an acquired sample image; and processing of acquiring the feature image in the selected mode, and wherein the plurality of modes include: a first mode in which the measurement unit scans the sample at a first scanning speed to capture the sample image and the image acquisition unit trims the captured sample image to acquire the feature image; and a second mode in which the measurement unit scans the sample at a second scanning speed that is higher than the first scanning speed to capture the sample image, and scans the region of the feature object in the captured sample image at a third scanning speed that is lower than the second scanning speed to capture the feature image.

## Description

### BACKGROUND OF THE INVENTION

### Field of the Invention

The present invention relates to a charged particle beam apparatus and an analysis method.

### Description of Related Art

Particle analysis using a scanning electron microscope (SEM), an electron probe micro analyzer (EPMA) or the like is known.

For example, JP 2015-148499 A discloses a method of acquiring a backscattered electron image or a secondary electron image, extracting particles with a threshold value of contrast set in advance on a standard sample or the like, and measuring characteristic X-rays with an energy dispersive X-ray spectrometer to thereby repeatedly perform measurement until measurement of all preset field-of-view ranges is finished while categorizing the particles using an intensity value or a concentration value of the characteristic X rays.

In particle analysis, particle images are repeatedly acquired and analyzed for a large number of particles. Therefore, particle analysis requires long-time measurement to acquire the particle images.

### SUMMARY OF THE INVENTION

According to a first aspect of the present disclosure, there is provided a charged particle beam apparatus including:
a measurement unit that scans a sample with a charged particle beam to capture a sample image;
an image acquisition unit that acquires a plurality of sample images captured by the measurement unit from a plurality of regions of the sample, and acquires a feature image that is an image of a feature object contained in the sample from each of the plurality of sample images; and
an analysis unit that acquires information on the feature object based on the feature image,
wherein the image acquisition unit acquires a plurality of feature images by repeating
processing of selecting one mode from among a plurality of modes to acquire the feature image based on a proportion of a region of the feature object occupying a field of view in an acquired sample image, and
processing of acquiring the feature image in the selected mode, and
wherein the plurality of modes include
a first mode in which the measurement unit scans the sample at a first scanning speed to capture the sample image and the image acquisition unit trims the captured sample image to acquire the feature image, and
a second mode in which the measurement unit scans the sample at a second scanning speed that is higher than the first scanning speed to capture the sample image, and scans the region of the feature object in the captured sample image at a third scanning speed that is lower than the second scanning speed to capture the feature image.

According to a second aspect of the present disclosure, there is provided an analysis method in a charged particle beam apparatus that scans a sample with a charged particle beam to capture a sample image, the method including:
acquiring a plurality of sample images captured from a plurality of regions of the sample and acquiring a feature image that is an image of a feature object contained in the sample from each of the plurality of sample images; and
acquiring information on the feature object based on the feature image,
wherein in the acquiring of the feature image, a plurality of feature images are acquired by repeating
selecting one mode from among a plurality of modes to acquire the feature image based on a proportion of a region of the feature object occupying a field of view in an acquired sample image, and
acquiring the feature image in the selected mode, and
wherein the plurality of modes include
a first mode in which the sample is scanned at a first scanning speed to capture the sample image and the captured sample image is trimmed to acquire the feature image, and
a second mode in which the sample is scanned at a second scanning speed that is higher than the first scanning speed to capture the sample image, and the region of the feature object in the captured sample image is scanned at a third scanning speed that is lower than the second scanning speed to capture the feature image.

### BRIEF DESCRIPTION OF THE DRAWINGS

FIG. 1 is a diagram illustrating an example of a configuration of an electron microscope according to the first embodiment.
FIG. 2 is a diagram illustrating an example of a configuration of a particle analysis apparatus.
FIG. 3 illustrates a first mode.
FIG. 4 illustrates a second mode.
FIG. 5 is a diagram for explaining a particle analysis method.
FIG. 6 is a diagram for explaining a particle analysis method.
FIG. 7 is a diagram for explaining a particle analysis method.
FIG. 8 is a flowchart illustrating an example of a flow of particle analysis processing of the particle analysis apparatus.
FIG. 9 is a diagram for explaining a particle analysis method.
FIG. 10 is a diagram for explaining a particle analysis method.
FIG. 11 is a diagram for explaining a particle analysis method.
FIG. 12 is a diagram for explaining a particle analysis method.
FIG. 13 is a diagram for explaining a particle analysis method.
FIG. 14 is a diagram for explaining a particle analysis method.
FIG. 15 is a diagram for explaining an order of analyzing each region of a sample.

### DESCRIPTION OF THE INVENTION

According to an embodiment of the present disclosure, there is provided a charged particle beam apparatus including:
a measurement unit that scans a sample with a charged particle beam to capture a sample image;
an image acquisition unit that acquires a plurality of sample images captured by the measurement unit from a plurality of regions of the sample, and acquires a feature image that is an image of a feature object contained in the sample from each of the plurality of sample images; and
an analysis unit that acquires information on the feature objects based on the feature image,
wherein the image acquisition unit acquires a plurality of feature images by repeating
processing of selecting one mode from among a plurality of modes to acquire the feature image based on a proportion of a region of the feature object occupying a field of view in an acquired sample image, and
processing of acquiring the feature image in the selected mode, and
wherein the plurality of modes include
a first mode in which the measurement unit scans the sample at a first scanning speed to capture the sample image and the image acquisition unit trims the captured sample image to acquire the feature image, and
a second mode in which the measurement unit scans the sample at a second scanning speed that is higher than the first scanning speed to capture the sample image, and scans the region of the feature object in the captured sample image at a third scanning speed that is lower than the second scanning speed to capture the feature image.

Such a charged particle beam apparatus can shorten a time for acquiring feature images.

According to an embodiment of the present disclosure, there is provided an analysis method in a charged particle beam apparatus that scans a sample with a charged particle beam to capture a sample image, the method including:
acquiring a plurality of sample images captured from a plurality of regions of the sample and acquiring a feature image that is an image of a feature object contained in the sample from each of the plurality of sample images; and
acquiring information on the feature object based on the feature image,
wherein in the acquiring of the feature images, a plurality of feature images are acquired by repeating
selecting one mode from among a plurality of modes to acquire the feature image based on a proportion of a region of the feature object occupying a field of view in an acquired sample image, and
acquiring the feature image in the selected mode, and
wherein the plurality of modes include
a first mode in which the sample is scanned at a first scanning speed to capture the sample image and the captured sample image is trimmed to acquire the feature image, and
a second mode in which the sample is scanned at a second scanning speed that is higher than the first scanning speed to capture the sample image, and the region of the feature object in the captured sample image is scanned at a third scanning speed that is lower than the second scanning speed to capture the feature image.

Such an analysis method can shorten a time for acquiring feature images.

Preferred embodiments of the invention will be described in detail with reference to the drawings. The embodiments described below are not intended to unduly limit the contents of the invention described in the claims. Further, all of the components described below are not necessarily essential requirements of the invention.

Hereinafter, a scanning electron microscope for scanning a sample with an electron beam and capturing a sample image will be described as an example of a charged particle beam apparatus according to the invention. Note that the charged particle beam apparatus according to the invention may be an apparatus that scans a sample with a charged particle beam (an ion beam or the like) other than an electron beam to capture a sample image.

### 1. First Embodiment

### 1.1. Configuration of Electron Microscope

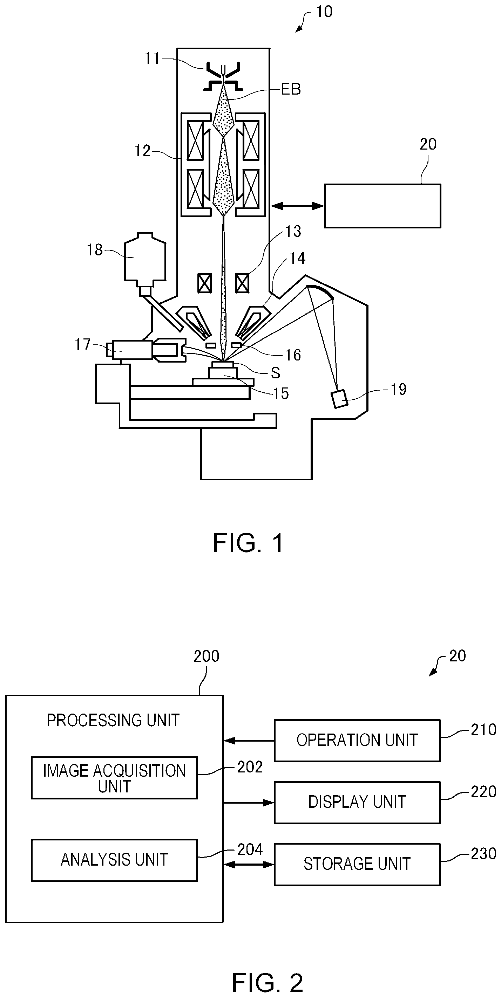

First, an electron microscope according to the first embodiment will be described with reference to the drawings. FIG. 1 is a diagram illustrating an example of a configuration of an electron microscope 100 according to the first embodiment.

As illustrated in FIG. 1, the electron microscope 100 includes a measurement unit 10 and a particle analysis device 20.

The measurement unit 10 scans a sample S with an electron beam EB, detects electrons generated in the sample S, and captures a sample image. The sample image is an image obtained by scanning the sample S with a probe formed by the electron beam EB or the like and detecting a signal (electrons, X-rays or the like) generated from the sample S. The sample image includes a secondary electron image and a backscattered electron image.

The measurement unit 10 includes an electron source 11, a converging lens 12, a scanning deflector 13, an objective lens 14, a sample stage 15, a backscattered electron detector 16, a secondary electron detector 17, an energy dispersive X-ray spectrometer 18, and a wavelength dispersive X-ray spectrometer 19.

The electron source 11 emits the electron beam EB. The electron source 11 is, for example, an electron gun that accelerates electrons emitted from a negative electrode by a positive electrode and emits the electron beam EB.

The converging lens 12 converges the electron beam EB emitted from the electron source 11 to form an electron probe together with the objective lens 14. An aperture angle of the electron beam EB can be adjusted by the converging lens 12.

The scanning deflector 13 two-dimensionally deflects the electron beam EB. The sample S can be scanned by the electron probe by the scanning deflector 13 deflecting the electron beam EB.

The objective lens 14 is a lens for forming an electron probe disposed immediately before the sample S. The objective lens 14 includes, for example, a coil and a yoke. In the objective lens 14, lines of magnetic force generated by the coil are confined in the yoke made of a material with high magnetic permeability, and notches are formed in a part of the yoke, thereby causing the lines of magnetic force distributed with high density to leak onto an optical axis.

The sample S is placed on the sample stage 15. The sample stage 15 supports the sample S. The sample stage 15 has a drive mechanism for causing the sample S to move. The position of the sample S irradiated with the electron beam EB can be moved through the movement of the sample stage 15.

The backscattered electron detector 16 detects backscattered electrons generated in the sample S by the sample S being irradiated with the electron beam EB. The backscattered electrons are electrons that have popped out in a process in which electrons that have been incident on the sample S are scattered by elements constituting the sample S. The backscattered electron detector 16 is disposed immediately below the objective lens 14, for example. The backscattered electron detector 16 has an annular shape, and the sample S is irradiated with the electron beam EB having passed through the center hole of the backscattered electron detector 16. The backscattered electron detector 16 is, for example, a silicon semiconductor detector.

The secondary electron detector 17 detects secondary electrons emitted from the sample S by the sample S being irradiated with the electron beam EB. The secondary electrons are those obtained by exciting electrons in a solid and emitting the electrons to a vacuum through non-elastic scattering of the incident electrons. The secondary electron detector 17 is, for example, an Everhart-Thornley (ET) detector.

The energy dispersive X-ray spectrometer (EDS) 18 is a detector for distinguishing X-rays based on their energy to obtain a spectrum. The energy dispersive X-ray spectrometer 18 detects characteristic X-rays generated in the sample S by the sample S being irradiated with the electron beam EB. This allows EDS spectra to be acquired.

A wavelength dispersive X-ray spectrometer 19 (WDS) separates and detects X-rays of a specific wavelength using Bragg reflection of X-rays by a spectroscopic crystal. The wavelength dispersive X-ray spectrometer 19 obtains a spectrum for each wavelength of the characteristic X-rays, which have been generated in the sample S by the sample S being irradiated with an electron beam EB, by using the Bragg reflection by the spectroscopic crystal.

The particle analysis device 20 performs particle analysis. In other words, the particle analysis device 20 captures a plurality of sample images from a plurality of regions of the sample S, obtains particle images that are images of particles contained in the sample S from each of the plurality of sample images, and obtains information on particles based on the particle images. The information on the particles includes, for example, information on the shapes of the particles, such as the sizes of the particles, and information on the positions of the particles. Furthermore, the particle analysis device 20 performs EDS analysis or WDS analysis on the particle based on the information on the positions of the particles and acquires information on a composition of the particles. The information on the particles includes information on the composition of the particles.

FIG. 2 is a diagram illustrating an example of a configuration of the particle analysis device 20. As illustrated in FIG. 2, the particle analysis device 20 includes a processing unit 200, an operation unit 210, a display unit 220, and a storage unit 230.

The operation unit 210 is used by a user to input operation information and outputs the input operation information to the processing unit 200. The function of the operation unit 210 can be realized by an input device such as a keyboard, a mouse, a button, a touch panel, or a touch pad.

The display unit 220 displays an image generated by the processing unit 200. The function of the display unit 220 can be realized by a liquid crystal display (LCD), a touch panel display, or the like.

The storage unit 230 stores programs, data, and the like for the processing unit 200 to perform various kinds of calculation processing and various kinds of control processing. Moreover, the storage unit 230 is also used as a work area for the processing unit 200, and is also used to temporarily store calculation results and the like executed by the processing unit 200 in accordance with various programs. The functions of the storage unit 230 can be realized by a random access memory (RAM), a read only memory (ROM), a hard disk, and the like.

The function of the processing unit 200 can be realized by various kinds of processors such as a central processing unit (CPU), a graphics processing unit (GPU), or a digital signal processor (DSP) executing the programs stored in the storage unit 230. The processing unit 200 includes an image acquisition unit 202 and an analysis unit 204.

The image acquisition unit 202 acquires sample images captured by the measurement unit 10 and acquires particle images from the acquired sample images. The image acquisition unit 202 repeatedly performs the processing of acquiring the sample images and the processing of acquiring the particle images from the sample images to acquire a plurality of particle images.

The analysis unit 204 acquires information on the particles based on the plurality of particle images acquired by the image acquisition unit 202.

### 1.2. Method of Acquiring Particle Images

### 1.2.1. Particle Image Acquisition Modes

The electron microscope 100 has a first mode and a second mode as modes for acquiring particle images.

### 1.2.2. First Mode

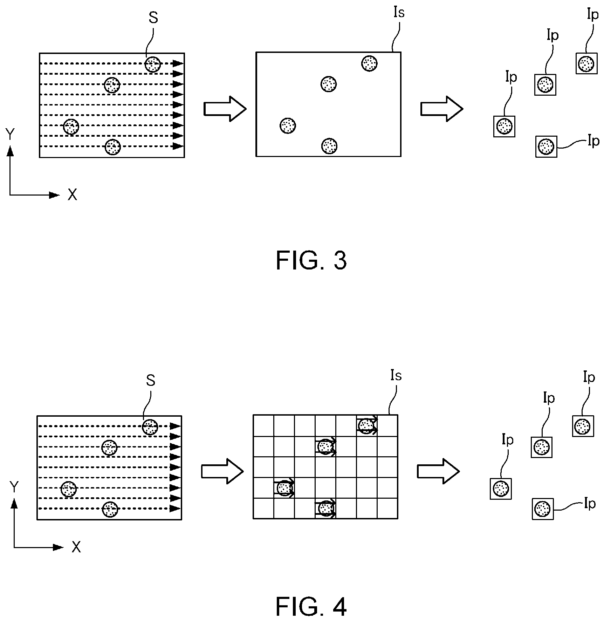

FIG. 3 illustrates the first mode.

In the first mode, the measurement unit 10 scans the sample S at a first scanning speed and captures a sample image Is first. The first scanning speed is set to a scanning speed at which the shapes of the particles can be confirmed. The scanning speed is a speed of scanning of the electron probe, and the scanning speed increases as the dwell time per pixel decreases. For example, a sample image of 1,024 × 768 pixels is captured at a scanning speed corresponding to a dwell time of 4 µs/pixel per pixel in the first mode. Note that the first scanning speed can be changed as appropriate in accordance with accuracy required for the particle analysis.

The scanning of the sample S with the electron probe is performed through raster scanning. In other words, the sample S is scanned by repeatedly drawing a scanning line in a +X direction with the electron probe, moving the position where the scanning line is drawn in a -Y direction perpendicular to the +X direction, and then drawing a scanning line in the +X direction with the electron probe.

Next, particle regions are trimmed from the sample image Is through image processing to obtain particle images Ip. For example, the sample image Is is binarized, and contours of the particles are detected from the binary sample image Is. It is thus possible to extract regions of the particles from the sample image Is. Next, regions including all the regions of the particles extracted from the sample image Is are cut out, and the particle images Ip can thus be generated. It is thus possible to acquire the particle images Ip in the first mode.

### 1.2.3. Second Mode

FIG. 4 illustrates the second mode.

In the second mode, the measurement unit 10 scans the sample S at a second scanning speed that is higher than the first scanning speed and captures a sample image Is first. The second scanning speed is set to a speed at which particles can be confirmed. For example, a sample image of 1,024 × 768 pixels is captured at a scanning speed corresponding to a dwell time of 1 µs/pixel per pixel in the second mode. Note that the second scanning speed can be changed as appropriate in accordance with accuracy required for the particle analysis.

Next, particle regions are detected through image processing in the sample image Is, and the measurement unit 10 scans a region including all the particle regions in the sample S at a third scanning speed that is lower than the second scanning speed based on a result of detecting the particle regions to thereby capture the particle images Ip. The third scanning speed is, for example, the same as the first scanning speed. For example, the particle images Ip are captured at a scanning speed corresponding to a dwell time of 4 µs/pixel per pixel in the second mode. Note that the third scanning speed is not particularly limited as long as it is lower than the second scanning speed, and may be lower than the first scanning speed, or may be higher than the first scanning speed, for example. In this manner, the particle images Ip can be acquired in the second mode.

### 1.2.4. Time for Acquiring Particle Images

In the first mode, when the number of pixels (resolution) of the sample image Is is denoted by R, and a dwell time per pixel is denoted by D, a time for capturing the sample image Is is represented as a product R × D of the number R of pixels and the dwell time D. Note that the time for trimming the sample image Is to obtain the particle images Ip is significantly shorter than the image capturing time and can thus be ignored. Thus, the acquisition time for acquiring the particle images Ip in the first mode is represented as the product R × D.

In the second mode, on the assumption that the dwell time per pixel when the sample image Is is captured is defined as D1, the time for capturing the sample image Is is represented as a product R × D1 of the number R of pixels and the dwell time D1. Also, when the number of pixels in the particle regions in the sample image Is is denoted by S, and the dwell time per pixel is denoted by D2, the time for capturing the particle images Ip is represented as a product S × D2 of the number S of pixels in the particle regions and the dwell time D2. Therefore, the acquisition time for acquiring the particle images in the second mode is represented as R × D1 + S × D2.

Depending on the proportion of the particle regions occupying the field of view in the sample image Is, the time for acquiring the particle images Ip in the second mode becomes shorter than the time for acquiring the particle images Ip in the first mode, or the time for acquiring the particle images Ip in the first mode becomes shorter than the time for acquiring the particle images Ip in the second mode.

The proportion of particles occupying the field of view can be represented by the number S of pixels in the particle regions in the sample image Is on the assumption that the resolution of the sample image Is is constant. Therefore, if the number S of pixels in the particle regions becomes smaller than a predetermined number, then the time R × D1 + S × D2 for acquiring the particle images Ip in the second mode becomes shorter than the time R × D for acquiring the particle images Ip in the first mode. Also, if the number S of pixels in the particle regions becomes larger than the predetermined number, the time R × D for acquiring the particle images Ip in the first mode becomes shorter than the time R × D1 + S × D2 for acquiring the particle images Ip in the second mode. Therefore, it is possible to shorten the time for acquiring the particle images Ip by switching the modes according to the number S of pixels in the particle regions.

When the time R × D for acquiring the particle images Ip in the first mode is shorter than the time R × D1 + S × D2 for acquiring the particle images Ip in the second mode, R × D < R × D1 + S × D2 is established. Therefore, when S > (R × (D - D1)) / D2 is satisfied, the time R × D for acquiring the particle images Ip in the first mode becomes shorter than the time R × D1 + S × D2 for acquiring the particle images Ip in the second mode. Therefore, the particle images Ip are acquired in the first mode when the number S of pixels in the particle regions is greater than a threshold value (R × (D - D1)) / D2, and the particle images Ip are acquired in the second mode when the number S of pixels in the particle regions is equal to or less than the threshold value (R × (D - D1)) / D2). It is thus possible to shorten the time for acquiring the particle images Ip.

Here, the proportion of the particles occupying the field of view cannot be known in a region to be imaged from now, that is, in a region before image capturing. Therefore, the proportion of the particles occupying the field of view in the region to be imaged from now is estimated from the acquired sample image Is. Specifically, the number of pixels in the particle regions is calculated in each acquired sample image, an average number of pixels is calculated, and the average number of pixels is compared with a threshold value to thereby select a mode for acquiring the region to be imaged from now.

### 1.3. Particle Analysis Method

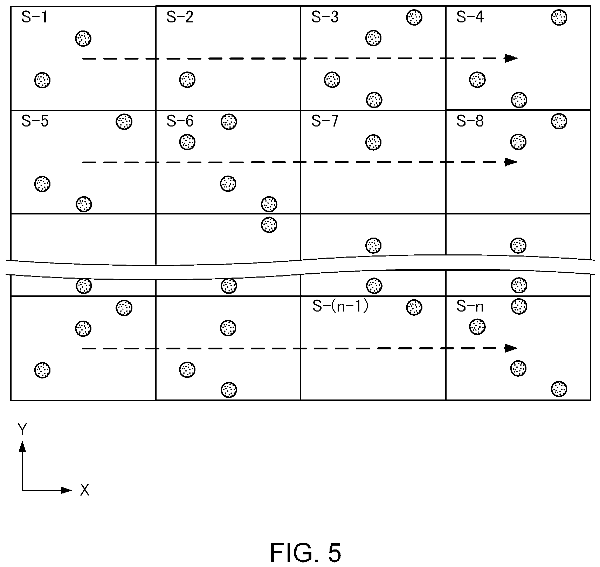

FIGS. 5 to 7 are diagrams for explaining a particle analysis method. FIGS. 5 to 7 illustrate an X axis and a Y axis perpendicularly intersecting each other.

In the particle analysis, the analysis is performed from a region S-1 in the first column in the order of a region S-2, a region S-3, and a region S-4 in the +X direction as illustrated in FIG. 5. After the analysis is performed up to the last region S-4 in the first column, the analysis is moved in the -Y direction, and the analysis is performed in the +X direction in order from the first region S-5 in the second column. The analysis is performed in a similar order for the regions in the third and following columns. In this manner, the analysis from the region S-1 to a region S-n (n is an integer that is equal to or greater than two) is performed.

First, the region S-1 of the sample S is analyzed. In the region S-1, a particle image Ip-1 is acquired in an initially set first mode because there are no sample images that have already been acquired. Then, information on the positions (coordinates) of particles and information on the shapes of the particles are acquired from the particle image Ip-1 through image processing. Next, EDS analysis is performed on the particles to obtain particle composition information. Through the above processes, the information on the particles in the region S-1 can be acquired. Note that although the particle image Ip-1 is acquired in the first mode by setting the first mode as initial setting in the above description, the second mode may be set as initial setting, and the particle image Ip-1 in the region S-1 may be acquired in the second mode.

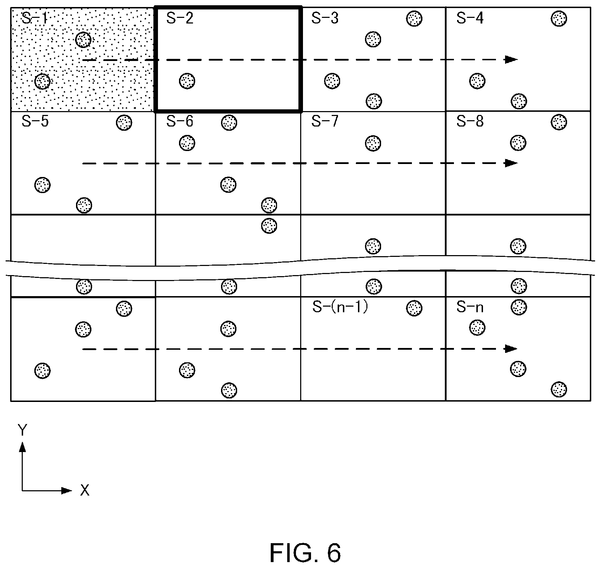

Next, the region S-2 of the sample S is analyzed as illustrated in FIG. 6. First, a mode for acquiring a particle image Ip-2 in the region S-2 is selected. The mode selection is performed based on the proportion of the particle regions occupying the field of view in the acquired sample image. Here, the average number of pixels in the particle regions in the sample image is used as the proportion of the particles occupying the field of view. The number of pixels in the particle regions in the sample image is obtained by detecting a contour of a particle from the particle image Ip-1 through image processing and counting the number of pixels in the contour.

As illustrated in FIG. 6, since the acquired sample image is only the region S-1, the number of pixels in the particle regions in the region S-1 is used as the average number S of pixels. When the average number S of pixels in the acquired sample image is larger than a threshold value (R × (D - D1)) / D2, a sample image Is-2 is acquired in the first mode. When the average number S of pixels is equal to or less than the threshold value, the sample image Is-2 is acquired in the second mode.

Next, information on the positions of the particles and information on the shapes of the particles are acquired through image processing from the acquired particle image Ip-2, and EDS analysis is performed on the particles to acquire particle composition information, similarly to the region S-1. Through the above processes, the information on the particles in the region S-2 can be acquired.

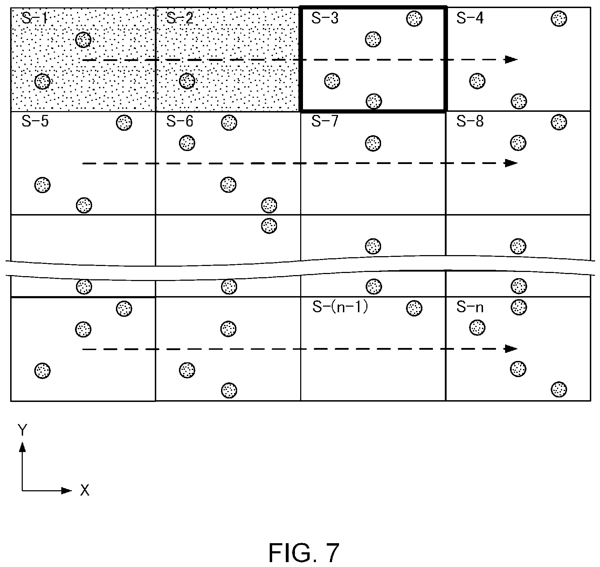

Next, the region S-3 of the sample S is analyzed as illustrated in FIG. 7. First, a mode for acquiring a particle image Ip-3 in the region S-3 is selected. In the mode selection, the number of pixels in the particle regions in the acquired sample image Is-1 and the number of pixels in the particle regions in the sample image Is-2 are calculated first, and the average number S of pixels is calculated. Then, when the average number S of pixels is larger than the threshold value, the particle image Ip-3 is acquired in the first mode. When the average number S of pixels is equal to or less than the threshold value, the particle image Ip-3 is acquired in the second mode. It is thus possible to select a mode. Next, information on the positions of the particles and information on the shapes of the particles are acquired through image processing from the acquired particle image Ip-3, and particle composition information is acquired through EDS analysis, similarly to the region S-1 and the region S-2. Through the above processes, the information on the particles in the region S-3 can be acquired.

When a region S-m (m is an integer that is equal to or greater than two) is analyzed, for example, the number of pixels in the particle regions is calculated in each of the sample image Is-1, the sample image Is-2, ..., and the sample image Is-(m - 1) that have been acquired, and the average number S of pixels is thereby calculated. Then, when the average number S of pixels is larger than the threshold value, a particle image Ip-m is acquired in the first mode. When the average number S of pixels is equal to or less than the threshold value, the particle image Ip-m is acquired in the second mode. Next, information on the positions of the particles and information on the shapes of the particles are acquired through image processing from the acquired particle image Ip-m, and particle composition information is acquired through EDS analysis. Through the above processes, information on the particles in the region S-m can be acquired. In this manner, the analysis is performed from the region S-1 to the region S-n.

### 1.4. Processing

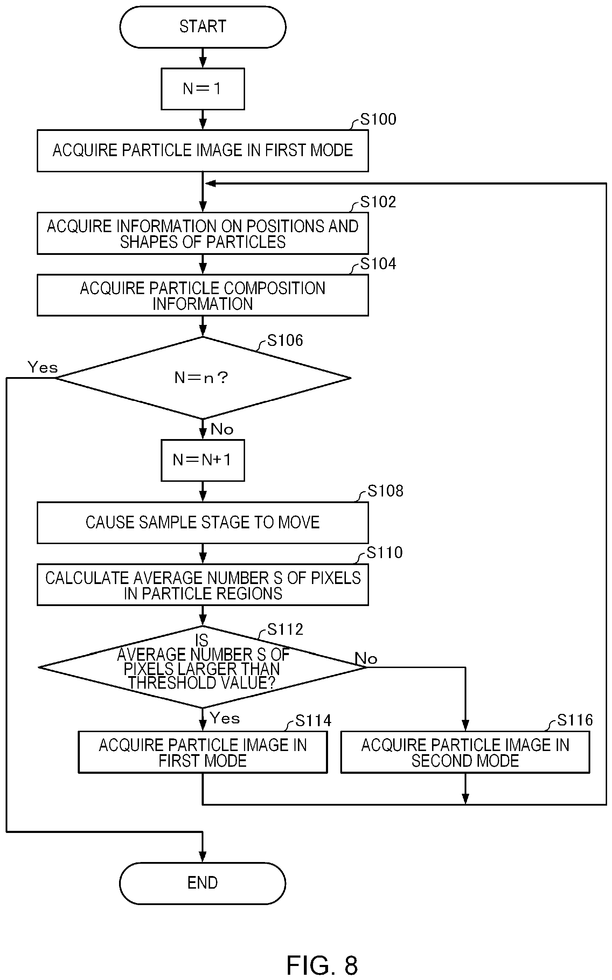

FIG. 8 is a flowchart illustrating an example of a flow of the particle analysis processing of the particle analysis device 20.

Here, a region to be analyzed in the sample S is set by a user in advance. The image acquisition unit 202 divides the region to be analyzed for each scanning range of an electron beam and determines a region to be analyzed at one time. Here, the image acquisition unit 202 divides the region to be analyzed into n pieces and performs analysis from a region S-1 (N = 1) to the region S-n (N = n) in order.

Once the user inputs an instruction to start particle analysis to the particle analysis device 20 via the operation unit 210, the image acquisition unit 202 sets N = 1 and acquires the particle image Ip-1 in the first mode in the region S-1 of the sample S (Step S100). The image acquisition unit 202 scans the region S-1 of the sample S at the first scanning speed to acquire the sample image Is-1. Next, the image acquisition unit 202 detects particle regions from the sample image Is-1 and acquires the particle image Ip-1 by trimming the particle regions from the sample image Is-1.

Next, the analysis unit 204 acquires information on the positions of the particles and information on the shapes of the particles by performing image processing on the acquired particle image Ip-1 (Step S102).

Next, the analysis unit 204 acquires particle composition information from a result of EDS analysis performed by the measurement unit 10 (Step S104). The analysis unit 204 identifies particles in the sample S from the information on the positions of the particles and causes the measurement unit 10 to irradiate the particles in the sample S with the electron beam EB. Characteristic X-rays emitted from the particles through the irradiation with the electron beam EB are detected by the energy dispersive X-ray spectrometer 18, and an EDS spectrum is obtained. In this manner, the analysis unit 204 acquires the EDS spectrum. The analysis unit 204 performs qualitative analysis and quantitative analysis on the EDS spectrum to acquire particle composition information.

Note that although the case where the analysis unit 204 performs the EDS analysis has been described here, the analysis unit 204 may perform the WDS analysis to acquire the particle composition information. Also, the analysis unit 204 may perform both the EDS analysis and the WDS analysis to acquire the particle composition information.

Next, the image acquisition unit 202 determines whether or not the analysis of the last region S-n among the regions to be analyzed of the sample S has ended, that is, whether or not N = n is satisfied (Step S106).

When it is determined that the analysis of the last region S-n has not ended, that is, when it is determined that N = n is not satisfied (No in Step S106), the image acquisition unit 202 increments N to N + 1, causes the sample S to move to the sample stage 15, and causes the scanning range to move from the region S-1 to the region S-2 (Step S108).

Next, the image acquisition unit 202 calculates the number S of pixels in the particle regions in the acquired sample image Is-1 (Step S110). The image acquisition unit 202 detects a contour of a particle in the sample image Is-1 and counts the number of pixels in the detected contour. Here, since only the sample image Is-1 is the acquired sample image, the number of pixels in the image regions in the sample image Is-1 is used as the average number S of pixels. Next, the image acquisition unit 202 determines whether or not the average number S of pixels is larger than the threshold value (R × (D - D1) / D2) (Step S112).

When it is determined that the average number S of pixels is larger than the threshold value (Yes in step S112), the image acquisition unit 202 acquires the particle image Ip-2 in the first mode (Step S114). The image acquisition unit 202 causes the measurement unit 10 to scan the sample S at the first scanning speed to capture the sample image Is-2, and trims the captured sample image Is-2 to acquire the particle image Ip-2.

Also, when it is determined that the average number S of pixels is equal to or less than the threshold value (No in Step S112), the image acquisition unit 202 acquires the particle image Ip-2 in the second mode (Step S116). The image acquisition unit 202 causes the measurement unit 10 to scan the sample S at the second scanning speed to capture the sample image Is-2. Next, the image acquisition unit 202 detects particle regions through image processing in the captured sample image Is-2 and causes the measurement unit 10 to scan the particle regions in the sample S at the third scanning speed that is lower than the second scanning speed based on the detection result to cause the measurement unit 10 to capture the particle image Ip-2. In this manner, the image acquisition unit 202 acquires the particle image Ip-2.

After the particle image Ip-2 is acquired in the first mode (after Step S114) or after the particle image Ip-2 is acquired in the second mode (after Step S116), the processing returns to Step S102, and the analysis unit 204 acquires information on the positions of the particles and information on the shapes of the particles through image processing from the particle image Ip-2 (Step S102). Next, the analysis unit 204 acquires particle composition information from a result of EDS analysis performed by the measurement unit 10 (Step S104).

The image acquisition unit 202 determines whether or not the analysis of the last region S-n has ended (Step S106), increments N to N + 1, causes the sample S to move to the sample stage 15, and causes the scanning range to move from the region S-2 to the region S-3 (Step S108) when it is determined that the analysis of the last region S-n has not ended (No in Step S106).

The image acquisition unit 202 calculates the number of pixels in the particle regions in the acquired sample image Is-1 and the number of pixels in the particle regions in the sample image Is-2, calculates the average number S of pixels (Step S110), and determines whether the average number S of pixels is larger than a threshold value (Step S112). When it is determined that the average number S of pixels is larger than the threshold value (Yes in Step S112), the image acquisition unit 202 acquires the particle image Ip-3 in the first mode (Step S114). When it is determined that the average number S of pixels is equal to or less than the threshold value (No in Step S112), the image acquisition unit 202 acquires the particle image Ip-3 in the second mode (Step S116). The analysis unit 204 acquires information on the positions of the particles and information on the shapes of the particles from the particle image Ip-3 (Step S102), and acquires particle composition information from a result of EDS analysis (Step S104).

The image acquisition unit 202 and the analysis unit 204 repeats the processing in Step S108, Step S110, Step S112, Step S114, Step S116, Step S102, Step S104, and Step S106 until it is determined that the analysis of the last region S-n has ended.

When it is determined that the analysis of the last region S-n has ended (Yes in Step S106), the image acquisition unit 202 ends particle analysis processing.

### 1.5. Effect

The electron microscope 100 includes the measurement unit 10 that scans the sample S with the electron beam EB to capture sample images, the image acquisition unit 202 that acquires the plurality of sample images Is captured in a plurality of regions of the sample S and acquires particle images Ip that are images of particles contained in the sample S from each of the plurality of sample images Is, and the analysis unit 204 that acquires information on the particles based on the particle images Ip. Also, the image acquisition unit 202 repeats the processing of selecting one mode from the plurality of modes for acquiring the particle images Ip based on the proportion of the particle regions occupying the fields of view in the acquired sample images Is and processing of acquiring the particle images Ip in the selected mode to thereby acquire a plurality of particle images Ip. The plurality of modes include the first mode in which the sample S is scanned at the first scanning speed to capture the sample image Is and the captured sample image Is is trimmed to acquire the particle images Ip, and the second mode in which the sample S is scanned at the second scanning speed that is higher than the first scanning speed to capture the sample image Is, the particle regions in the captured sample image Is are scanned at the third scanning speed that is lower than the second scanning speed to capture the particle images Ip.

Therefore, the electron microscope 100 can shorten the time for acquiring the particle images. Therefore, the electron microscope 100 can perform particle analysis in a short period of time, for example. Also, the electron microscope 100 can extend measurement time for EDS analysis by shortening the time for acquiring the particle images and can thus improve accuracy of the EDS analysis, for example.

In the electron microscope 100, the image acquisition unit 202 calculates an average value of the numbers of pixels in the particle regions in the acquired sample images and selects one mode from among the plurality of modes based on the average value in the processing of selecting a mode. Therefore, the electron microscope 100 can accurately estimate the proportion of the particle regions occupying the field of view. Therefore, the electron microscope 100 can allow accurate selection of an acquisition mode and shorten the time for acquiring the particle images.

In the electron microscope 100, the image acquisition unit 202 obtains the numbers of pixels in the particle regions in each acquired sample image, calculates an average number of pixels, and acquires the particle images in the first mode when the average number of pixels is larger than the threshold value, in the processing of selecting a mode. Also, when the number of pixels in the sample image is denoted by R, the dwell time per pixel when the sample image is captured in the first mode is denoted by D, and the dwell time per pixel when the sample image is captured in the second mode is denoted by D1, and the dwell time per pixel when the particle image is captured in the second mode is denoted by D2, the threshold value is (R × (D - D1)) / D2. Therefore, the electron microscope 100 can shorten the time for acquiring the particle images.

In the electron microscope 100, the dwell time of the electron beam EB per pixel when the sample image is captured in the second mode is shorter than the dwell time of the electron beam EB per pixel when the sample image is captured in the first mode. Therefore, the second scanning speed can be higher than the first scanning speed.

The analysis method of the electron microscope 100 includes a process of acquiring a plurality of sample images captured in a plurality of regions of the sample S and acquiring particle images including images of particles contained in the sample S from each of the plurality of sample images and a process of acquiring information on the particles based on the particle images. Also, in the process of acquiring the particle images, the plurality of particle images are acquired by repeating the process of selecting one mode from among the plurality of modes for acquiring the particle images based on the proportion of the particle regions occupying the field of view in the acquired sample image and process of acquiring the particle images in the selected mode. Also, the plurality of modes include the first mode in which the sample S is scanned at the first scanning speed to capture the sample image and the captured sample image is trimmed to acquire the particle images and the second mode in which the sample S is scanned at the second scanning speed that is higher than the first scanning speed to capture the sample image, the particle regions in the captured sample image are scanned at the third scanning speed that is lower than the second scanning speed to capture the particle images.

Therefore, according to the analysis method of the electron microscope 100, it is possible to shorten the time for acquiring the particle images.

### 2. Second Embodiment

### 2.1. Electron Microscope

Next, an electron microscope according to the second embodiment will be described. A construction of the electron microscope according to the second embodiment is similar to the aforementioned configuration of the electron microscope 100 illustrated in FIGS. 1 and 2, and description thereof will be omitted.

### 2.2. Particle Analysis Method

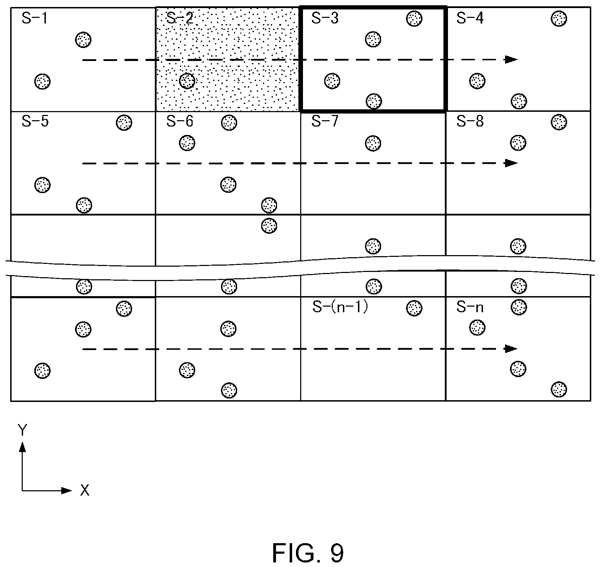

FIGS. 9 to 11 are diagrams for explaining a particle analysis method. Hereinafter, differences from the aforementioned example of the particle analysis method according to the first embodiment will be described, and description of similar points will be omitted.

In the aforementioned first embodiment illustrated in FIGS. 6 and 7, the average number of pixels in the pixel regions is calculated in the acquired sample images, and a mode is selected depending on whether or not the average number of pixels is larger than the threshold value.

On the other hand, in the second embodiment, an average number of pixels in particle regions in a sample image in a second region that is adjacent to a first region, which is a sample image that has been acquired, is calculated when a sample image in the first region of the sample S is captured, and a mode is selected depending on whether or not the average number of pixels is larger than a threshold value. Hereinafter, a particle analysis method according to the second embodiment will be described with reference to FIGS. 9 to 11.

First, analysis of a region S-1 of the sample S is performed. The analysis of the region S-1 is performed similarly to the aforementioned first embodiment. Next, analysis of a region S-2 of the sample S is performed. For the region S-2, the sample image in the adjacent region, which is a sample image that has been acquired, is only the sample image Is-1 in the region S-1. Therefore, the analysis of the region S-2 of the sample S is performed similarly to the aforementioned process of analyzing the region S-2 in the first embodiment.

Next, analysis of a region S-3 of the sample S is performed as illustrated in FIG. 9. For the region S-3, the sample image in the adjacent region, which is a sample image that has been acquired, is only the sample image Is-2. Therefore, the number of pixels in the particle regions in the sample image Is-2 is calculated. Then, a particle image Ip-3 is acquired in a first mode when the calculated average number S of pixels is larger than a threshold value (R × (D - D1)) / D2, and the particle image Ip-3 is acquired in a second mode when the average number of pixels is equal to or less than the threshold value.

Next, analysis of a region S-4 of the sample S is performed. For the region S-4, the sample image in the adjacent region, which is a sample image that has been acquired, is only the sample image Is-3. Therefore, the number of pixels in particle regions in the sample image Is-3 is calculated. Then, a particle image Ip-4 is acquired in the first mode when the calculated average number S of pixels is larger than the threshold value (R × (D - D1)) / D2, and the particle image Ip-4 is acquired in the second mode when the average number of pixels is equal to or less than the threshold value.

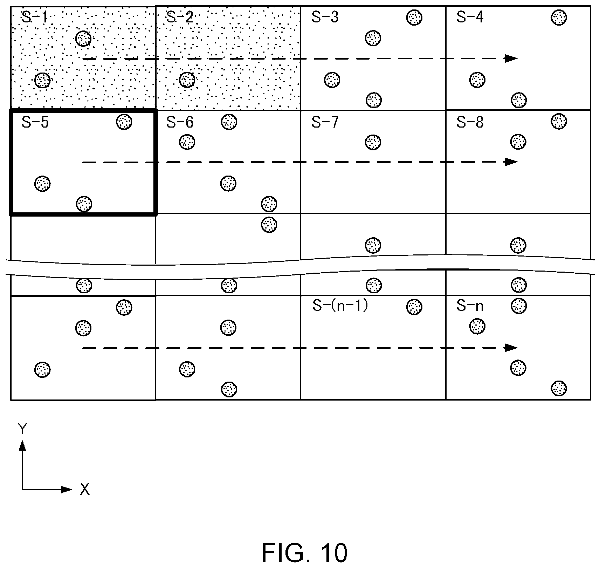

Next, analysis of a region S-5 of the sample S is performed as illustrated in FIG. 10. For the region S-5, the sample images in regions adjacent to the region S-5, which are sample images that have been acquired, are the sample image Is-1 and the sample image Is-2. Therefore, the number of pixels in the particle regions in the sample image Is-1 and the number of pixels in the particle regions in the sample image Is-2 are calculated, and the average number S of pixels is calculated. Then, a particle image Ip-5 is acquired in the first mode when the average number S of pixels is larger than the threshold value (R × (D - D1)) / D2, and the particle image Ip-5 is acquired in the second mode when the average number S of pixels is equal to or less than the threshold value.

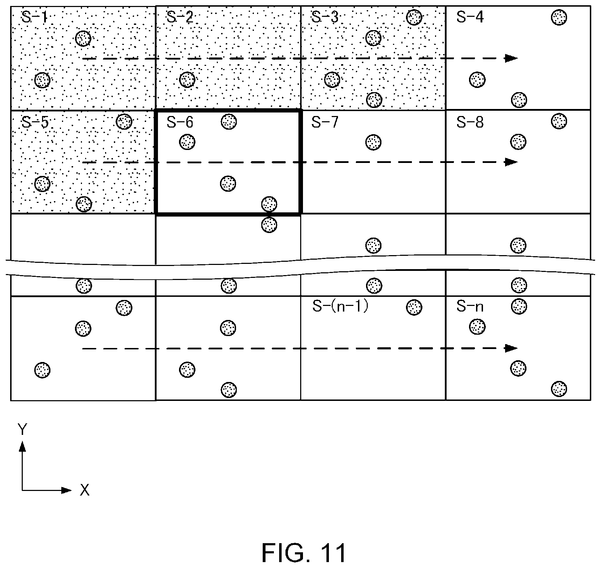

Next, analysis of a region S-6 of the sample S is performed as illustrated in FIG. 11. For the region S-6, the sample images in regions adjacent to the region S-6, which are the acquired sample images, are four sample images, namely the sample image Is-1, the sample image Is-2, the sample image Is-3, and the sample image Is-5. Therefore, the number of pixels in the particle regions is calculated in each of the four sample images, and the average number S of pixels is obtained. Then, a particle image Ip-6 is acquired in the first mode when the calculated average number S of pixels is larger than the threshold value (R × (D - D1)) / D2, and the particle image Ip-6 is acquired in the second mode when the average number S of pixels is equal to or less than the threshold value. In this manner, the analysis is performed from the region S-1 to the region S-n.

### 2.3. Processing

Particle analysis processing of the electron microscope 100 according to the second embodiment is similar to the particle analysis processing of the electron microscope 100 according to the first embodiment other than that processing of calculating the average number S of pixels in the particle regions illustrated in Step S110 in FIG. 8 is different. Hereinafter, differences from the aforementioned example of the particle analysis method according to the first embodiment will be described, and description of similar points will be omitted.

In Step S110, when the sample image in the first region of the sample S is captured, an image acquisition unit 202 calculates the average number S of pixels in the particle regions in the sample image in the second region that is adjacent to the first region, which is a sample image that has been acquired, and determines whether or not the average number S of pixels is larger than the threshold value. Then, the image acquisition unit 202 acquires the particle image in the first mode when the average number S of pixels is larger than the threshold value, and acquires the particle image in the second mode when the average number S of pixels is equal to or less than the threshold value.

### 2.4. Effect

In the electron microscope 100, the image acquisition unit 202 calculates an average value of the numbers of pixels in the particle regions in the sample image in the second region that is adjacent to the first region, which is a sample image that has been acquired when the sample image in the first region of the sample S is captured, and selects one mode from among the plurality of modes based on the average value in the processing of selecting a mode. Therefore, the electron microscope 100 can accurately estimate the proportion of the particle regions occupying the field of view. Therefore, the electron microscope 100 can allow accurate selection of an acquisition mode and shorten the time for acquiring the particle images.

### 3. Third Embodiment

### 3.1. Electron Microscope

Next, an electron microscope according to the third embodiment will be described. A construction of the electron microscope according to the third embodiment is similar to the aforementioned configuration of the electron microscope 100 illustrated in FIGS. 1 and 2, and description thereof will be omitted.

### 3.2. Particle Analysis Method

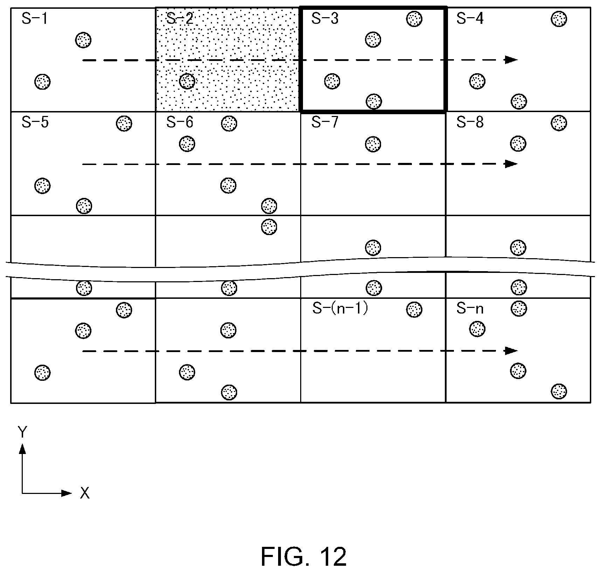

FIGS. 12 to 14 are diagrams for explaining a particle analysis method. Hereinafter, differences from the aforementioned example of the particle analysis method according to the first embodiment will be described, and description of similar points will be omitted.

In the aforementioned first embodiment illustrated in FIGS. 6 and 7, the average number S of pixels in the particle regions in the acquired sample images is calculated, and a mode is selected depending on whether or not the average number S of pixels is larger than the threshold value.

On the other hand, in the third embodiment, when a sample image in a second region is captured after a sample image in a first region, and the sample image in the first region and the sample image in the second region are adjacent, the number of pixels in particle regions in the sample image in the first region is calculated, and a mode is selected whether or not the number of pixels is larger than a threshold value. In other words, the number of pixels in the particle regions is calculated in the sample image that has been captured immediately before, and the number of pixels is compared with the threshold value to select a mode.

On the other hand, when the sample image in the first region and the sample image in the second region are not adjacent, the number of pixels in particle regions is calculated in a sample image in a third region that is adjacent to the second region, and a mode is selected depending on whether or not the number of pixels is larger than the threshold value.

First, analysis of a region S-1 of the sample S is performed. The analysis of the region S-1 is performed similarly to the aforementioned first embodiment. Next, analysis of a region S-2 of the sample S is performed. For the region S-2, the region that has been imaged immediately before is the region S-1. Therefore, the number of pixels in particle regions is calculated in the sample image Is-1. Then, a particle image Ip-2 is acquired in a first mode when the calculated number S of pixels is larger than a threshold value (R × (D - D1)) / D2, and the particle image Ip-2 is acquired in a second mode when the number S of pixels is equal to or less than the threshold value.

Next, analysis of a region S-3 is performed as illustrated in FIG. 12. For the region S-3, the region that has been imaged immediately before is the region S-2. Therefore, the number of pixels in particle regions is calculated in the sample image Is-2. Then, a particle image Ip-3 is acquired in the first mode when the calculated number S of pixels is larger than the threshold value (R × (D - D1)) / D2, and the particle image Ip-3 is acquired in the second mode when the number S of pixels is equal to or less than the threshold value.

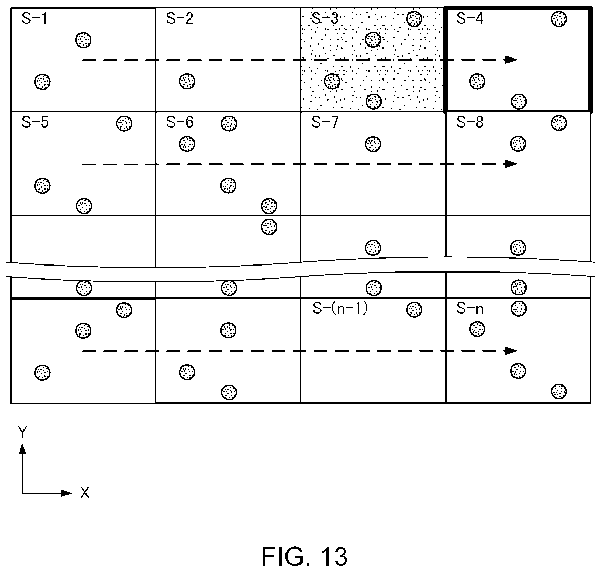

Next, analysis of a region S-4 is performed as illustrated in FIG. 13. For the region S-4, the region that has been imaged immediately before is the region S-3. Therefore, the number of pixels in particle regions is calculated in the sample image Is-3. Then, a particle image Ip-4 is acquired in the first mode when the calculated number S of pixels is larger than the threshold value (R × (D - D1)) / D2, and the particle image Ip-4 is acquired in the second mode when the number of pixels is equal to or less than the threshold value.

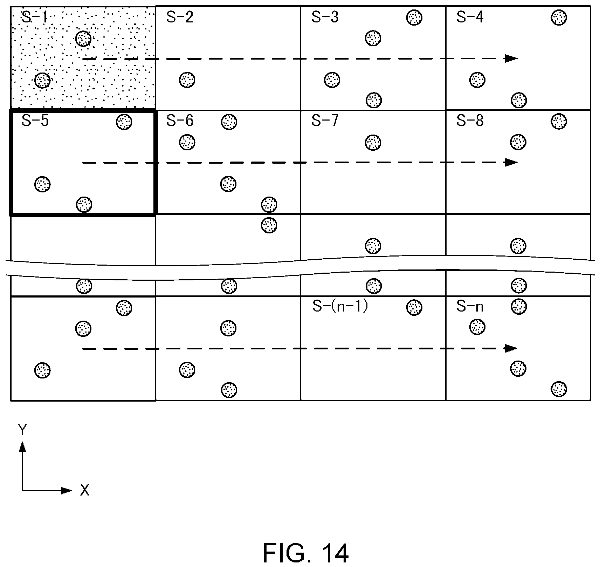

Next, analysis of a region S-5 is performed as illustrated in FIG. 14. For the region S-5, the region that has been imaged immediately before is the region S-4. However, the region S-4 is located at the end of the region to be analyzed in the +X direction, and the region S-5 is located at the end in the -X direction. In other words, the region S-4 and the region S-5 are not adjacent. In this case, the number S of pixels in particle regions is calculated in the sample image Is-1 in the region S-1 that is adjacent to the region S-5. Then, a particle image Ip-5 is acquired in the first mode when the calculated number S of pixels is larger than the threshold value (R × (D - D1)) / D2, and the particle image Ip-5 is acquired in the second mode when the number S of pixels is equal to or less than the threshold value.

Here, the region S-1 with the maximum length of side in contact with the region S-5 is selected as a region adjacent to the region S-5. Note that the average number of pixels may be calculated by calculating the numbers of pixels in the particle regions in the acquired sample images in all the regions adjacent to the region S-5 as regions adjacent to the region S-5. For example, since the region S-1 and the region S-2 are adjacent to the region S-5, the average number of pixels may be calculated by calculating the number of pixels in the particle regions in the sample image Is-1 and the number of pixels in the particle regions in the sample image Is-2.

### 3.3. Processing

Particle analysis processing of the electron microscope 100 according to the third embodiment is similar to the particle analysis processing of the electron microscope 100 according to the first embodiment other than that processing of calculating the average number S of pixels in the particle regions illustrated in Step S110 in FIG. 8 is different. Hereinafter, differences from the aforementioned example of the particle analysis method according to the first embodiment will be described, and description of similar points will be omitted.

In the step S110, when the sample image in the second region is captured after the sample image in the first region, and the sample image in the first region and the sample image in the second region are adjacent, the image acquisition unit 202 calculates the number of pixels in the particle regions in the sample image in the first region, and a mode is selected depending on whether or not the number of pixels is larger than the threshold value. Also, when the sample image in the first region and the sample image in the second region are not adjacent, the number of pixels in particle region is calculated in the sample image in the third region that is adjacent to the second region, and a mode is selected depending on whether or not the number of pixels is larger than the threshold value.

### 3.4. Effect

In the electron microscope 100, when the sample image in the second region is imaged after the sample image in the first region, and the sample image in the first region and the sample image in the second region are adjacent, the image acquisition unit 202 calculates the number of pixels in the particle regions in the sample image in the first region and selects a mode depending on whether or not the number of pixels is larger than the threshold value, in the processing of selecting a mode. Also, when the sample image in the first region and the sample image in the second region are not adjacent, the number of pixels in the particle regions is calculated in the sample image in the third region that is adjacent to the second region, and a mode is selected depending on whether or not the number of pixels is larger than the threshold value. Therefore, the electron microscope 100 can accurately estimate the proportion of the particle regions occupying the field of view. Therefore, the electron microscope 100 can accurately select a mode and shorten the time for acquiring the particle images.

### 3.5. Modification Examples

Although the image acquisition unit 202 calculates the number of pixels in the particle regions in the sample image in the third region that is adjacent to the second region when the sample image in the second region is imaged after the sample image in the first region, and the sample image in the first region and the sample image in the second region are not adjacent in the aforementioned third embodiment, the number of pixels in the particle regions may be calculated in the sample image in the first region even when the sample image in the first region and the sample image in the second region are not adjacent. In other words, the image acquisition unit 202 may constantly calculate the number of pixels in the particle regions in the sample image in the first region in the case where the sample image in the second region is captured after the sample image in the first region, and may select a mode depending on whether or not the number of pixels is larger than the threshold value in the processing of selecting a mode.

### 4. Modification Examples

### 4.1. First Modification Example

In the aforementioned first to third embodiments, the dwell time of the electron beam per pixel when the sample image is captured in the second mode is shorter than the dwell time of the electron beam per pixel when the sample image is captured in the first mode. Therefore, the second scanning speed when the sample image is captured in the second mode is higher than the first scanning speed when the sample image is captured in the first mode.

On the other hand, a resolution of the sample image in the second mode may be set to be lower than a resolution of the sample image in the first mode with the dwell time of the electron beam per pixel kept constant. In this manner, the second scanning speed when the sample image is captured in the second mode can be higher than the first scanning speed when the sample image is captured in the first mode. The resolution of the sample image corresponds to the number of pixels in the sample image. The scanning speed is inversely proportional to the resolution (the number of pixels) of the sample image. Therefore, it is possible to increase the scanning speed by lowering the resolution of the sample image, that is, by reducing the number of pixels of the sample image. The resolution of the sample image in the second mode is set to a resolution that allows the particles to be observed, for example. Note that the resolution of the sample image in the second mode can be changed as needed in accordance with accuracy required for the particle analysis.

The resolution of the particle image in the second mode is set to be higher than the resolution of the sample image in the second mode. The resolution of the particle image in the second mode may be the same as the resolution of the sample image in the first mode or may be higher than the resolution of the sample image in the first mode.

### 4.2. Second Modification Example

In the aforementioned first to third embodiments, the particle images that are images of particles contained in the sample S are acquired from the sample images, and information on the particles is acquired. In other words, although the particles contained in the sample S are the target of analysis, the target of analysis is not limited to the particles.

For example, the electron microscope 100 may acquire feature images that are images of feature objects contained in the sample S from sample images and acquire information on the feature objects. The feature objects may be, for example, defects such as crystal defects or may be inclusions in steel. The defects and the inclusions are imaged with contrasts different from that for a base material of the sample S similarly to particles in a sample image such as a secondary electron image or a backscattered electron image. Therefore, the feature objects such as defects and inclusions can be extracted from the sample image through image processing similarly to the aforementioned particles. Therefore, the feature objects such as defects and inclusions can be analyzed by a method similar to the aforementioned particle analysis.

### 4.3. Third Modification Example

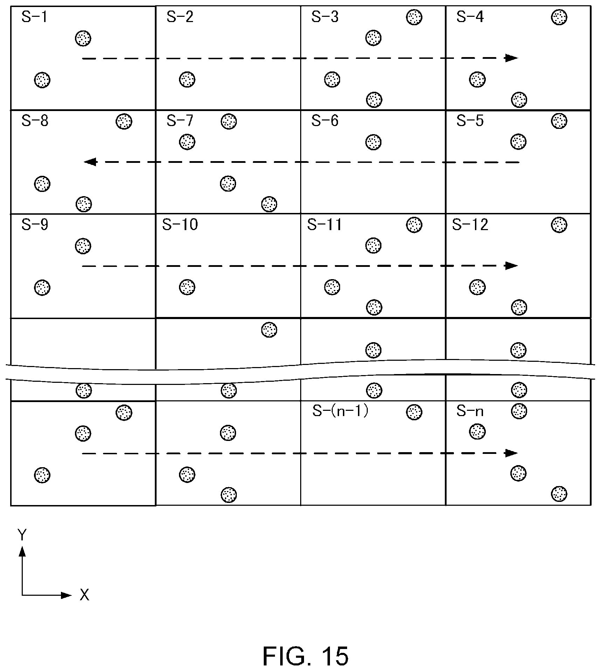

FIG. 15 is a diagram for explaining an order of analyzing each region of the sample S.

In the aforementioned first to third embodiments, each region in the first column is analyzed in order in the +X direction, on the analysis is moved in the -Y direction, and each region in the second column is analyzed in order in the +X direction, as illustrated in FIG. 5. The analysis is performed in a similar order on the second and following columns, and all the regions to be analyzed of the sample S are analyzed.

On the other hand, in the third modification example, each region in the first column is analyzed in order in the +X direction, the processing then moves on in the -Y direction, and each region in the second column is analyzed in order in the -X direction as illustrated in FIG. 15. After each region in the second column is analyzed, the processing moves on in the -Y direction, and each region in the third column is analyzed in order in the +X direction. The analysis is performed in a similar order in the fourth and following columns, and all the regions to be analyzed of the sample S are analyzed.

Note that the order of analyzing each region of the sample S is not limited to those in the examples illustrated in FIGS. 5 and 15, and the analysis may be performed in an arbitrary order.

### 4.4. Fourth Modification Example

Although the average value (the average number S of pixels) of the numbers of pixels in the particle regions is compared with the threshold value in the plurality of acquired sample images in the aforementioned first embodiment, a representative value that represents the numbers of pixels in the particle regions is not limited to the average value. For example, a median or a mode of the numbers of pixels in the particle regions may be used as a representative value and may be compared with the threshold value.

### 4.5. Fifth Modification Example

Although the case where the charged particle beam apparatus according to the invention is a scanning electron microscope has been described in the aforementioned first to third embodiments, the charged particle beam apparatus according to the invention is not limited to the scanning electron microscope. The charged particle beam apparatus according to the invention may be, for example, a scanning transmission electron microscope (STEM), an electron probe micro-analyzer (EPMA), a focused ion beam apparatus (FIB), or the like. In other words, the charged particle beam apparatus according to the invention is not particularly limited as long as the apparatus can scan a sample with a charged particle beam such as an electron beam or an ion beam and capture a sample image.

Note that the aforementioned embodiments and modification examples are just examples, and the invention is not limited thereto. For example, the embodiments and the modification examples can be combined as appropriate.

The invention is not limited to the above-described embodiments, and various modifications can be made. For example, the invention includes configurations that are substantially the same as the configurations described in the embodiments. Substantially the same configurations mean configurations having the same functions or methods, for example. The invention also includes configurations obtained by replacing non-essential elements of the configurations described in the embodiments with other elements. The invention further includes configurations obtained by adding known art to the configurations described in the embodiments.

## Claims

1. A charged particle beam apparatus comprising:
a measurement unit that scans a sample with a charged particle beam to capture a sample image;
an image acquisition unit that acquires a plurality of sample images captured by the measurement unit from a plurality of regions of the sample, and acquires a feature image that is an image of a feature object contained in the sample from each of the plurality of sample images; and
an analysis unit that acquires information on the feature object based on the feature image,
wherein the image acquisition unit acquires a plurality of feature images by repeating
processing of selecting one mode from among a plurality of modes to acquire the feature image based on a proportion of a region of the feature object occupying a field of view in an acquired sample image, and
processing of acquiring the feature image in the selected mode, and
wherein the plurality of modes include
a first mode in which the measurement unit scans the sample at a first scanning speed to capture the sample image and the image acquisition unit trims the captured sample image to acquire the feature image, and
a second mode in which the measurement unit scans the sample at a second scanning speed that is higher than the first scanning speed to capture the sample image, and scans the region of the feature object in the captured sample image at a third scanning speed that is lower than the second scanning speed to capture the feature image.

2. The charged particle beam apparatus according to claim 1, wherein
in the processing of selecting a mode, the image acquisition unit calculates a representative value of proportion in the acquired sample image, and selects one mode from among the plurality of modes based on the representative value.

3. The charged particle beam apparatus according to claim 2, wherein
in the processing of selecting a mode, the image acquisition unit
obtains the numbers of pixels in the regions of the feature object in the acquired sample images to calculate an average number of pixels, and
acquires the feature image in the first mode when the average number of pixels is greater than a threshold value, and
when the number of pixels in the sample image is denoted by R, a dwell time per pixel in capturing the sample image in the first mode is denoted by D, a dwell time per pixel in capturing the sample image in the second mode is denoted by D1, and a dwell time per pixel in capturing the feature image in the second mode is denoted by D2, the threshold value is (R × (D - D1)) / D2.

4. The charged particle beam apparatus according to claim 1, wherein
in the processing of selecting a mode,
when the measurement unit captures a sample image of a first region of the sample, the image acquisition unit calculates a representative value of the proportion in an acquired sample image of a second region which is adjacent to the first region , and
the image acquisition unit selects one mode from among the plurality of modes based on the representative value.

5. The charged particle beam apparatus according to claim 1, wherein
in the processing of selecting a mode,
when the measurement unit captures a sample image of a first region of the sample followed by a sample image of a second region of the sample, the image acquisition unit calculates the proportion in the sample image in the first region, and
the image acquisition unit selects one mode from among the plurality of modes based on the proportion in the sample image in the first region.

6. The charged particle beam apparatus according to claim 1, wherein
in the processing of selecting a mode, when the measurement unit captures a sample image of a first region of the sample followed by a sample image of a second region of the sample, the image acquisition unit
calculates the proportion in the sample image of the first region and selects one mode from among the plurality of modes based on the proportion in the sample image of the first region when the first region and the second region are adjacent to each other, and
calculates the proportion in a sample image of a third region which is adjacent to the second region and selects one mode from among the plurality of modes based on the proportion in the sample image of the third region when the first region and the second region are not adjacent to each other.

7. The charged particle beam apparatus according to any one of claims 1 to 6, wherein
a dwell time of a charged particle beam per pixel when the measurement unit captures the sample image in the second mode is shorter than a dwell time of the charged particle beam per pixel when the measurement unit captures the sample image in the first mode.

8. The charged particle beam apparatus according to any one of claims 1 to 6, wherein
a resolution of the sample image in the second mode is lower than a resolution of the sample image in the first mode.

9. An analysis method in a charged particle beam apparatus that scans a sample with a charged particle beam to capture a sample image, the method comprising:
acquiring a plurality of sample images captured from a plurality of regions of the sample and acquiring a feature image that is an image of a feature object contained in the sample from each of the plurality of sample images; and
acquiring information on the feature object based on the feature image,
wherein in the acquiring of the feature image, a plurality of feature images are acquired by repeating
selecting one mode from among a plurality of modes to acquire the feature image based on a proportion of a region of the feature object occupying a field of view in an acquired sample image, and
acquiring the feature image in the selected mode, and
wherein the plurality of modes include
a first mode in which the sample is scanned at a first scanning speed to capture the sample image and the captured sample image is trimmed to acquire the feature image, and
a second mode in which the sample is scanned at a second scanning speed that is higher than the first scanning speed to capture the sample image, and the region of the feature object in the captured sample image is scanned at a third scanning speed that is lower than the second scanning speed to capture the feature image.
